(19) Europäisches Patentamt
European Patent Office
Office européen des brevets

(11) **EP 4 141 148 A1**

(12) **EUROPEAN PATENT APPLICATION**
published in accordance with Art. 153(4) EPC

(43) Date of publication:
**01.03.2023 Bulletin 2023/09**

(21) Application number: **21812330.5**

(22) Date of filing: **22.03.2021**

(51) International Patent Classification (IPC):
**C25D 3/12** *(2006.01)*          **C25D 5/12** *(2006.01)*
**H05K 3/24** *(2006.01)*

(52) Cooperative Patent Classification (CPC):
**C25D 3/12; C25D 5/12; H05K 3/24**

(86) International application number:
**PCT/KR2021/003483**

(87) International publication number:
**WO 2021/241865 (02.12.2021 Gazette 2021/48)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **28.05.2020 KR 20200064172**

(71) Applicant: **YMT Co., Ltd.**
**Incheon 21690 (KR)**

(72) Inventors:
• **CHUN, Sung Wook**
**Incheon 21996 (KR)**
• **CHUNG, Bo Mook**
**Incheon 21986 (KR)**
• **KIM, Dea Geun**
**Incheon 21551 (KR)**
• **KIM, Jung Il**
**Incheon 21957 (KR)**
• **KANG, Jin Seok**
**Seogwipo-si Jeju-do 63558 (KR)**

(74) Representative: **Prüfer & Partner mbB**
**Patentanwälte · Rechtsanwälte**
**Sohnckestraße 12**
**81479 München (DE)**

(54) **ELECTROLYTIC NICKEL PLATING SURFACE MODIFIER AND ELECTROLYTIC NICKEL PLATING SOLUTION COMPRISING SAME**

(57)     The present invention relates to a surface modifier for electrolytic nickel plating including at least one carboxyl group-containing compound and a nickel electroplating solution including the surface modifier. The use of the nickel electroplating solution according to the present invention enables efficient formation of a plated nickel layer with high surface roughness and mattness even without performing strong electrolysis, unlike in the prior art.

[Fig. 1]

**Preparative Example 1**

## Description

### Technical Field

The present invention relates to a surface modifier for electrolytic nickel plating that can be used to control the surface roughness and gloss of a electroplated nickel layer by electrolytic nickel plating and a nickel electroplating solution including the surface modifier.

### Background Art

Electrolytic gold plating and electroless gold plating are surface treatment processes for mounting passive components and active integrated circuits on printed circuit boards. Electrolytic gold plating is mainly used because electroless gold plating increases the possibility of peeling at the interface between gold and plated nickel layers during wire bonding.

Electrolytic gold plating processes can be divided into electrolytic soft gold plating and electrolytic hard gold plating depending on how they are implemented. Electrolytic soft gold plating can form plated gold layers with a porous structure and a low density because large gold particles are plated. Electrolytic hard gold plating can form plated gold layers with a high density because small gold particles are plated.

Electrolytic gold plating is performed to form a plated gold layer on an insulating substrate/plated copper layer/plated nickel layer structure. Here, control over the surface roughness and gloss of the plated nickel layer is required to ensure the adhesiveness of the plated gold layer and the reliability of a semiconductor package. That is, the plated nickel layer needs to have high surface roughness and mattness in order to improve the detection of defects on printed circuit boards in the surface mount technology (SMT) while increasing the adhesion (bonding) between the plated nickel layer and the plated gold layer.

Thus, according to the prior art, strong electrolysis is performed using a nickel sulfamate plating solution to form a plated nickel layer whose surface roughness and gloss are controlled. The application of an electric current for a long time during strong electrolysis promotes the hydrolysis of nickel sulfamate into hydroxyl and amine groups, which interfere with nickel plating growth to make the plated nickel layer rough.

However, strong electrolysis has many problems in that the long-term application of an electric current causes high power consumption, the precipitation and consumption of metal ions bring about a rise in the price of subsidiary materials, and the long process waiting time leads to low efficiency in forming a plated nickel layer. Further, strong electrolysis has a limitation in controlling the surface roughness and gloss of a plated nickel layer.

Thus, it is necessary to roughen the surface of a electroplated nickel layer using a universal nickel sulfamate plating solution while preserving the surface hardness and crystal texture of the plated nickel layer. That is, there is a need to develop a surface modifier that can control only the surface roughness of a plated nickel layer without affecting the surface of the plated nickel layer.

### Detailed Description of the Invention

### Technical Problem

The present invention intends to provide a surface modifier for electrolytic nickel plating that can be used to form a plated nickel layer having a matt surface whose roughness is improved.

The present invention also intends to provide a nickel electroplating solution that can be used to form a plated nickel layer with high efficiency.

The present invention also intends to provide a printed circuit board including a electroplated nickel layer using the nickel electroplating solution.

### Technical Solution

One aspect of the present invention provides a surface modifier for electrolytic nickel plating including at least one carboxyl group-containing compound and at least one sodium-containing compound.

The carboxyl group-containing compound may be a hydroxy acid.

The hydroxy acid may be selected from the group consisting of citric acid, lactic acid, tartaric acid, isocitric acid, salicylic acid, serine, threonine, glucaric acid, glucuronic acid, glyceric acid, and gallic acid.

The sodium-containing compound may be selected from the group consisting of sodium citrate, sodium acetate, sodium propionate, sodium hydroxide, sodium nitrate, sodium sulfate, and sodium sulfide.

The present invention also provides a nickel electroplating solution including at least one nickel ion source, at least one halide ion source, and the surface modifier for electrolytic nickel plating.

The nickel ion source may be selected from the group consisting of nickel sulfamate, nickel sulfate, nickel carbonate, and nickel acetate.

The halide ion source may be selected from the group consisting of nickel bromide and nickel chloride.

The surface modifier for electrolytic nickel plating may be present at a concentration of 0.5 to 10 g per liter of the nickel electroplating solution.

The nickel electroplating solution of the present invention may further include at least one additive selected from the group consisting of a pH buffer, a surface tension modifier, and a pH adjusting agent.

The present invention also provides a printed circuit board including an insulating substrate, a plated copper layer formed on the insulating substrate, a electroplated nickel layer on the plated copper layer, and a plated gold layer formed on the plated nickel layer wherein the plated nickel layer is formed using the nickel electroplating solution.

The plated nickel layer may have a surface gloss of 0.3 or less and a surface roughness (Ra) of 0.35 $\mu$m or more.

## Effects of the Invention

Due to the presence of the carboxyl group-containing compound in the surface modifier for electrolytic nickel plating, the use of the nickel electroplating solution including the surface modifier enables efficient formation of a plated nickel layer with high surface roughness and mattness even without performing strong electrolysis, unlike in the prior art. Therefore, the present invention can contribute to improving the efficiency and reliability of processes for manufacturing semiconductor packages.

## Brief Description of the Drawings

Figs. 1 to 5 are reference images for explaining Experimental Example 1 according to the present invention.
Figs. 6 to 8 are reference images for explaining Experimental Example 2 according to the present invention.

## Mode for Carrying out the Invention

It should be understood that the terms and words used in the specification and the claims are not to be construed as having common and dictionary meanings but are construed as having meanings and concepts corresponding to the technical spirit of the present invention in view of the principle that the inventor can define properly the concept of the terms and words in order to describe his/her invention with the best method.

The present invention is directed to a surface modifier for electrolytic nickel plating that can be used to efficiently control the surface roughness and gloss of a plated nickel layer, which is a surface to be subjected to electrolytic gold plating (especially electrolytic soft gold plating), and a nickel electroplating solution including the surface modifier. The surface modifier and the nickel electroplating solution will be described in detail.

The surface modifier of the present invention is used to prepare a nickel electroplating solution for forming a plated nickel layer by electrolytic plating. The use of the nickel electroplating solution increases the surface roughness of a plated nickel layer while making the plated nickel layer matt. The surface modifier of the present invention can be considered as an additive that is added to a nickel electroplating solution. The surface modifier of the present invention may include at least one carboxyl group-containing compound and at least one sodium-containing compound.

The carboxyl group-containing compound serves to supply functional groups that interfere with electrolytic plating of nickel (adsorption of nickel ions to be plated), resulting in the formation of a plated nickel layer that has a rough surface because nickel ions are not plated flat but are concentrated on protrusions. That is, the presence of the carboxyl group-containing compound leads to the formation of a plated nickel layer with high surface roughness (Ra) and mattness.

The carboxyl group-containing compound may be a hydroxy acid. The hydroxy acid refers to a compound having both carboxyl (-COOH) and hydroxyl groups (-OH) in the molecule. The presence of carboxyl and hydroxyl groups in the hydroxy acid enables the formation of a plated nickel layer with high surface roughness (Ra) and mattness. Specifically, the hydroxyl group in the hydroxy acid molecule forms a strong hydrogen bond between the functional groups. The hydroxyl group in the hydroxy acid molecule interferes with electrolytic plating of nickel ions because it is first adsorbed to an object to be plated due to its high electrostatic affinity resulting from the hydrogen bond. In addition, the carboxyl group in the hydroxy acid molecule tends to release a hydrogen ion and is converted to a hydroxyl group, which is first adsorbed to an object to be plated to interfere with electrolytic plating of nickel ions. The interference with electrolytic plating of nickel ions by the carboxyl and hydroxyl groups results in the formation of a plated nickel layer with high surface roughness (Ra) and mattness.

The hydroxy acid is specifically selected from the group consisting of citric acid, lactic acid, tartaric acid, isocitric acid, salicylic acid, serine, threonine, glucaric acid, glucuronic acid, glyceric acid, and gallic acid. The hydroxy acid may be citric acid in consideration of economic feasibility as well as the surface roughness and mattness of a plated nickel layer.

The sodium-containing compound serves to adjust the pH of the surface modifier. The sodium-containing compound allows the pH of the surface modifier to be at a level required as an additive added to a nickel electroplating solution.

The sodium-containing compound is specifically an organic compound selected from the group consisting of sodium citrate, sodium acetate, and sodium propionate or an inorganic compound selected from the group consisting of sodium hydroxide, sodium nitrate, sodium sulfate, and sodium sulfide.

The mixing ratio between the carboxyl group-containing compound and the sodium-containing compound is not particularly limited. For example, the weight ratio between the carboxyl group-containing compound and the sodium-containing compound may be 2:1 to 4:1, specifically 2.6:2 to 3:2.5, when the surface roughness and mattness of a plated nickel layer are taken into consideration.

The surface modifier of the present invention may further include at least one auxiliary compound (for example, glycine or glycine sulfate) to further increase the surface roughness and mattness of a plated nickel layer.

The nickel electroplating solution of the present invention includes the surface modifier. Specifically, the nickel electroplating solution of the present invention may include at least one nickel ion source, at least one halide ion source, and the surface modifier.

The nickel ion source serves to supply nickel ions to form a plated nickel layer. The nickel ion source is specifically selected from the group consisting of nickel sulfamate, nickel sulfate, nickel carbonate, and nickel acetate.

The concentration of the nickel ion source is not particularly limited. For example, the nickel ion source may be present at a concentration of 80 to 100 g, specifically 85 to 95 g, per liter of the nickel electroplating solution, considering easy formation of a plated nickel layer.

The halide ion source serves to dissolve an anode. The halide ion source is specifically selected from the group consisting of nickel bromide and nickel chloride.

The concentration of the halide ion source is not particularly limited. For example, the halide ion source may be present at a concentration of 1 to 7 g, specifically 2 to 5 g, per liter of the nickel electroplating solution, considering easy formation of a plated nickel layer.

The surface modifier serves to supply functional groups (for example, carboxyl and hydroxyl groups) that interfere with electrolytic plating of nickel (nickel ions) to allow a plated nickel layer to have high surface roughness and mattness. Specifically, the surface modifier can make the surface of a electroplated nickel layer by electrolytic plating matt. The surface modifier is the same as that described above and a description thereof will be omitted.

The concentration of the surface modifier is not particularly limited. For example, the surface modifier may be present at a concentration of 0.5 to 10 g, specifically 5 to 10 g, per liter of the nickel electroplating solution, considering the surface roughness and mattness of a plated nickel layer. The surface modifier may be added in a larger amount than its reference concentration (1 g/L) when used for a long time.

For easy formation of a plated nickel layer, the nickel electroplating solution of the present invention may further include at least one additive selected from the group consisting of a pH buffer, a surface tension modifier, and a pH adjusting agent.

The pH buffer is specifically selected from the group consisting of boric acid, fluoroboric acid, phosphoric acid, nitric acid, acetic acid, sulfamic acid, sodium acetate, and mixtures thereof.

The concentration of the pH buffer is not particularly limited. For example, the pH buffer may be present in a concentration of 35 to 45 g, specifically 37 to 43 g, per liter of the nickel electroplating solution, considering the pH of the nickel electroplating solution.

The surface tension modifier is specifically selected from the group consisting of sodium lauryl sulfate, sodium lauryl sulfosuccinate, sodium dodecyl sulfonate, sodium dodecyl benzenesulfonate, sodium laureth sulfate, sodium dioctyl sulfosuccinate, sodium sulfosuccinate, ammonium lauryl sulfate, and mixtures thereof.

The concentration of the surface tension modifier is not particularly limited. For example, the surface tension modifier may be present at a concentration of 0.1 to 1 g, specifically 0.2 to 0.6 g, per liter of the nickel electroplating solution, considering easy formation of a plated nickel layer.

The pH adjusting agent may be specifically sulfamic acid ($H_3NSO_3$)-containing diluent.

For easy formation of a plated nickel layer, the nickel electroplating solution of the present invention may have a pH of 3.5 to 4.5, specifically 3.7 to 4.3.

Due to the presence of the surface modifier, the nickel electroplating solution supplies functional groups that interfere with the plating of nickel (nickel ions) during electrolytic nickel plating, enabling the formation of a plated nickel layer having a rough surface, that is, a plated nickel layer with a high surface roughness. Therefore, the use of the nickel electroplating solution enables efficient formation of a plated nickel layer with high surface roughness and mattness even without performing strong electrolysis, unlike in the prior art, thus being effective in improving the manufacturing efficiency (in terms of cost reduction and productivity) of printed circuit boards and semiconductor packages.

Specifically, the nickel electroplating solution of the present invention can be used to manufacture a printed circuit board including a plated gold layer, which will be described in detail below.

The present invention also provides a printed circuit board including an insulating substrate, a plated copper layer, a plated nickel layer, and a plated gold layer.

The insulating substrate serves as an insulating layer and may be made of an insulating resin such as glass or an epoxy resin.

The plated copper layer is formed on the insulating substrate. The plated copper layer serves as a circuit layer and may be formed by a conventional electrolytic copper plating or electroless copper plating process. The plated copper layer may have a circuit pattern formed by fill plating of a photoresist, via holes, and through holes.

The plated nickel layer is formed on the plated copper layer. The plated nickel layer serves to increase the adhesion (bonding) between the plated copper layer and the plated gold layer and may be formed by electroplating with the nickel electroplating solution. Plating conditions for the formation of the plated nickel layer using the nickel electroplating solution are not particularly limited. For example, the plating may be performed at a temperature of 45 to 55 °C and a current density of 1 to 5 A/dm$^2$.

The electroplated nickel layer using the nickel electroplating solution may have a surface gloss of 0.3 or less (specifically 0.1 to 0.25) and a surface roughness (Ra) of 0.35 $\mu$m or more (specifically 0.45 to 0.75 $\mu$m). The surface gloss can be calculated by the following equation based on a spectrophotometric method.

$$[\text{Equation}]$$

$$\text{Surface gloss (T)} = (I/I_0) \times 100$$

where $I_0$ is the intensity of light (ultraviolet, visible or infrared light) before passing through the plated nickel layer and $I$ is the intensity of light (ultraviolet, visible or infrared light) after passing through the plated nickel layer.

For reference, when the surface gloss is 0.3 or less, the surface of the plated nickel layer is deep dark gray in color, as observed with the naked eye. Meanwhile, when the surface gloss exceeds 0.3, the surface of the plated nickel layer is light gray in color.

The plated gold layer is formed on the plated nickel layer and serves to provide a surface for wire bonding. The plated gold layer can be formed by a conventional electrolytic gold plating process (specifically electrolytic soft gold plating).

The plated nickel layer is formed using the above-described nickel electroplating solution. The plated nickel layer has a surface gloss of 0.3 or less, which indicates its high mattness, and a surface roughness as high as 0.35 $\mu$m or more. The surface properties of the plated nickel layer can minimize the number of defects detected by a light scattering detector in a semiconductor package manufactured using the printed circuit board of the present invention when the reliability of the semiconductor package is evaluated and can maintain a stable state in which the plated gold layer is bonded to wires.

The present invention will be more specifically explained with reference to the following examples. However, these examples are provided for illustrative purposes and do not serve to limit the scope of the invention. It will be obvious to those skilled in the art that various modifications and changes are possible without departing from the scope and spirit of the invention.

**[Example 1]**

Citric acid (240 g/l), sodium citrate (260 g/l), sodium acetate (300 g/l), sodium propionate (200 g/l), and glycine (1 g/l) were mixed together to prepare a surface modifier for electrolytic nickel plating.

**[Example 2]**

A surface modifier for electrolytic nickel plating was prepared in the same manner as in Example 1, except that lactic acid was used instead of citric acid.

**[Comparative Example 1]**

A surface modifier for electrolytic nickel plating was prepared in the same manner as in Example 1, except that ethyl formate was used instead of citric acid.

**[Preparative Example 1]**

Nickel sulfamate (Ni(SO$_3$NH$_2$)$_2$, 90 g/l), nickel bromide (Ni(II)Br$_2$, 3 g/l), boric acid (H$_3$BO$_3$, 40 g/l), sodium lauryl sulfate (0.4 g/l), a sulfamate-containing compound (SNP 500PH, 5 g/l), and the surface modifier (10 g/l) of Example 1 were mixed together to prepare a nickel electroplating solution.

**[Preparative Example 2]**

A nickel electroplating solution was prepared in the same manner as in Preparative Example 1, except that the surface modifier of Example 2 was used instead of the surface modifier of Example 1.

**[Comparative Preparative Example 1]**

A nickel electroplating solution was prepared in the same manner as in Preparative Example 1, except that the surface modifier for electrolytic nickel plating of Comparative Example 1 was used instead of the surface modifier of Example 1.

**[Comparative Preparative Example 2]**

A nickel electroplating solution was prepared in the same manner as in Preparative Example 1, except that the surface modifier of Example 1 was excluded.

**[Experimental Example** 1]

Electrolytic nickel plating was performed on a copper substrate under the conditions shown in Table 1 to form a plated nickel layer.

[Table 1]

| Conditions | |
|---|---|
| Temperature (°C) | 50 °C |
| pH | 4.0 |
| Applied current density (A/dm$^2$) | 5 |
| Anode materials | Sulphur activated nickel |
| Agitation | Air & mechanical agitation |
| Anode: Cathode electrode size ratio | 1:1-3:1 |
| Plating rate | 0.205 μm-dm$^2$/min |

The surface gloss and surface roughness of the plated nickel layer were determined as follows.

- The surface gloss of the plated nickel layer was determined with a SE detector based on spectrophotometry.
- The surface roughness (Ra) of the plated nickel layer was determined with a SE detector by an ordinary method.

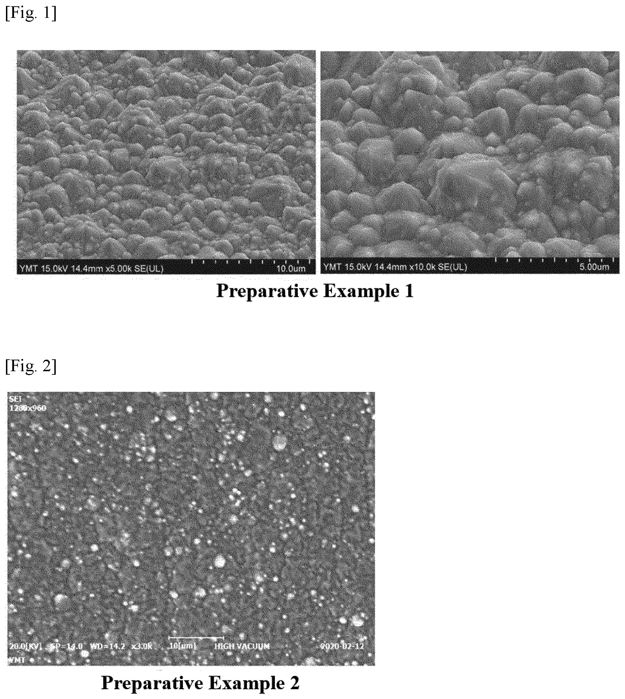

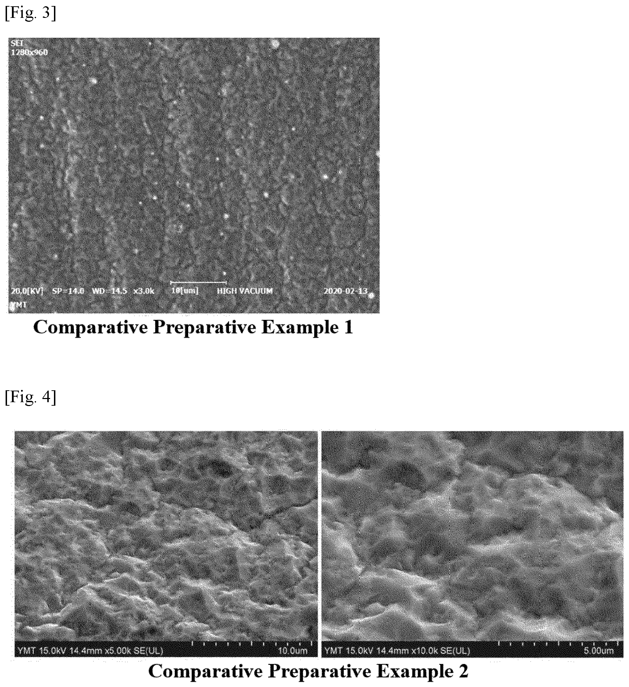

The results are shown in Figs. 1 to 5.
Figs. 1 to 4 are SEM images showing the surface glosses of the plated nickel layers formed using the nickel electroplating solutions of Preparative Examples 1 and 2 and Comparative Preparative Examples 1 and 2, respectively. The surface glosses were 0.23 (Preparative Example 1), 0.30 (Preparative Example 2), 0.32 (Comparative Preparative Example 1), and 0.35 (Comparative Preparative Example 2). The lower surface glosses of the plated nickel layers formed using the nickel electroplating solutions of Preparative Examples 1 and 2 than the surface glosses of the plated nickel layers formed using the nickel electroplating solutions of Comparative Preparative Examples 1 and 2 indicate better mattness of the plated nickel layers formed using the nickel electroplating solutions of Preparative Examples 1 and 2.

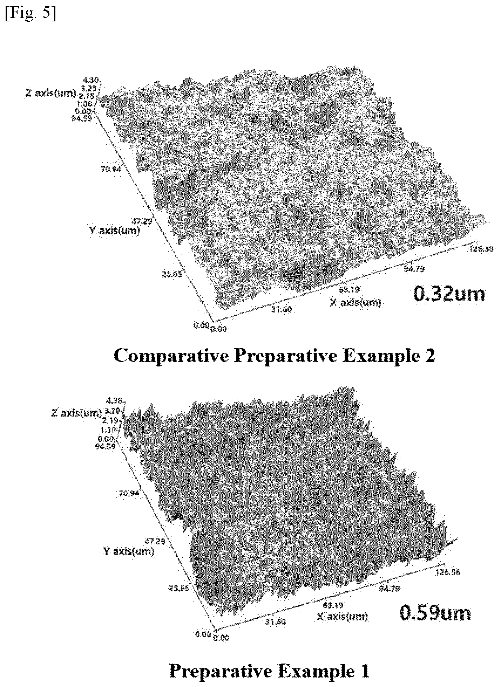

Fig. 5 shows the surface roughnesses of the plated nickel layers formed using the nickel electroplating solutions of Preparative Example 1 and Comparative Preparative Example 2. The surface roughness of the electroplated nickel layer using the nickel electroplating solution of Preparative Example 1 was 0.59 μm, which was higher than that (0.32 μm) of the electroplated nickel layer using the nickel electroplating solution of Comparative Preparative Example 2.

**[Experimental Example 2]**

A plated nickel layer was formed in the same manner as in Experimental Example 1. The following physical properties of the plated nickel layer were evaluated as follows.

- Wire bondability: Electrolytic soft gold plating was performed on the plated nickel layer by a conventional method, gold wires were bonded to the plated gold layer, and a peel test was conducted.
- Surface hardness: After a force was applied to the plated nickel layer using an indenter under a load of 25 gf for 10 sec in accordance with the KS B 0811 2003 testing standard with a Micro Vickers hardness tester, the surface size of the indenter was measured to determine the surface hardness of the plated nickel layer.
- Homogeneous electrodeposition coatability: a Hull cell test was conducted.

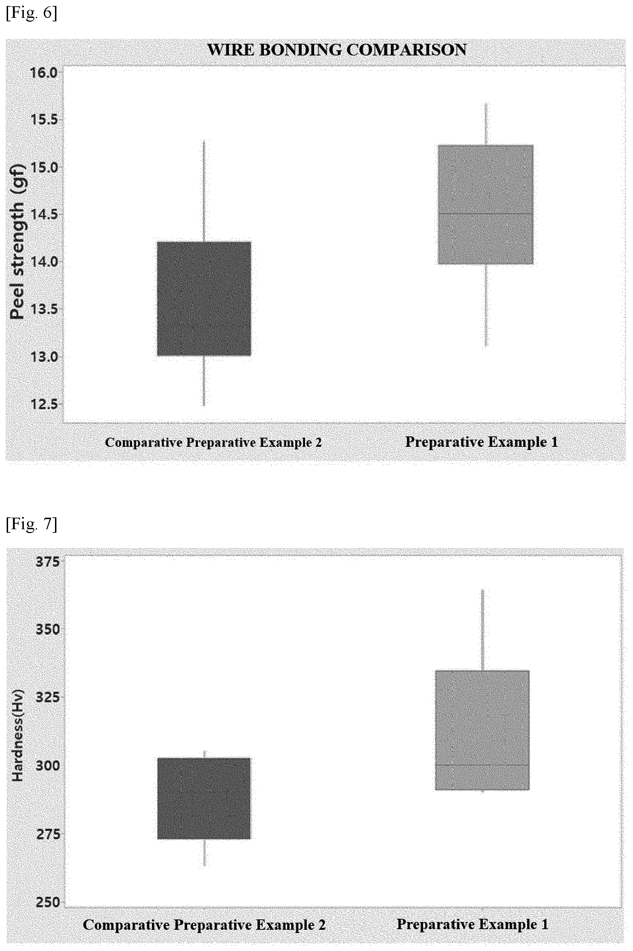

The results are shown in Figs. 6 to 8.

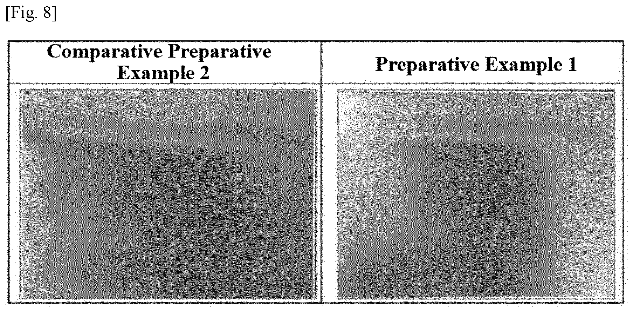

Referring to Fig. 6, the wire bondability of the electroplated nickel layer using the nickel electroplating solution of Preparative Example 1 was better than that of the electroplated nickel layer using the nickel electroplating solution of Comparative Preparative Example 1. Referring to Fig. 7, the surface hardness of the electroplated nickel layer using the nickel electroplating solution of Preparative Example 2 was higher than that of the electroplated nickel layer using the nickel electroplating solution of Comparative Preparative Example 2. Referring to Fig. 8, nickel was well plated despite the addition of the inventive surface modifier for electrolytic nickel plating (Preparative Example 1).

**Claims**

1. A surface modifier for electrolytic nickel plating comprising at least one carboxyl group-containing compound and at least one sodium-containing compound.

2. The surface modifier for electrolytic nickel plating according to claim 1, wherein the carboxyl group-containing compound is a hydroxy acid.

3. The surface modifier for electrolytic nickel plating according to claim 2, wherein the hydroxy acid is selected from the group consisting of citric acid, lactic acid, tartaric acid, isocitric acid, salicylic acid, serine, threonine, glucaric acid, glucuronic acid, glyceric acid, and gallic acid.

4. The surface modifier for electrolytic nickel plating according to claim 1, wherein the sodium-containing compound is selected from the group consisting of sodium citrate, sodium acetate, sodium propionate, sodium hydroxide, sodium nitrate, sodium sulfate, and sodium sulfide.

5. A nickel electroplating solution comprising at least one nickel ion source, at least one halide ion source, and the surface modifier for electrolytic nickel plating according to any one of claims 1 to 4.

6. The nickel electroplating solution according to claim 5, wherein the nickel ion source is selected from the group consisting of nickel sulfamate, nickel sulfate, nickel carbonate, and nickel acetate.

7. The nickel electroplating solution according to claim 5, wherein the halide ion source is selected from the group consisting of nickel bromide and nickel chloride.

8. The nickel electroplating solution according to claim 5, further comprising at least one additive selected from the group consisting of a pH buffer, a surface tension modifier, and a pH adjusting agent.

9. The nickel electroplating solution according to claim 5, wherein the surface modifier is present at a concentration of 0.5 to 10 g per liter of the nickel electroplating solution.

10. A printed circuit board comprising an insulating substrate, a plated copper layer formed on the insulating substrate, a electroplated nickel layer on the plated copper layer, and a plated gold layer formed on the plated nickel layer wherein the plated nickel layer is formed using the nickel electroplating solution according to claim 5.

11. The printed circuit board according to claim 10, wherein the plated nickel layer has a surface gloss of 0.3 or less and a surface roughness (Ra) of 0.35 $\mu$m or more.

[Fig. 1]

**Preparative Example 1**

[Fig. 2]

**Preparative Example 2**

[Fig. 3]

**Comparative Preparative Example 1**

[Fig. 4]

**Comparative Preparative Example 2**

[Fig. 5]

**Comparative Preparative Example 2**

**Preparative Example 1**

[Fig. 6]

[Fig. 7]

[Fig. 8]

| Comparative Preparative Example 2 | Preparative Example 1 |
|---|---|
| | |

## INTERNATIONAL SEARCH REPORT

| International application No. |
|---|
| **PCT/KR2021/003483** |

**A. CLASSIFICATION OF SUBJECT MATTER**

**C25D 3/12**(2006.01)i; **C25D 5/12**(2006.01)i; **H05K 3/24**(2006.01)i

According to International Patent Classification (IPC) or to both national classification and IPC

**B. FIELDS SEARCHED**

Minimum documentation searched (classification system followed by classification symbols)

C25D 3/12(2006.01); C23C 2/02(2006.01); C23C 22/34(2006.01); C25D 5/14(2006.01); C25D 5/48(2006.01); H05K 1/11(2006.01); H05K 3/24(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 니켈(nickel), 구리(copper), 금(gold), 회로기판(PCB), 시트르산(citric acid), 소듐 (sodium)

**C. DOCUMENTS CONSIDERED TO BE RELEVANT**

| Category* | Citation of document, with indication, where appropriate, of the relevant passages | Relevant to claim No. |
|---|---|---|
| X | KR 10-2014-0044768 A (COVENTYA S.P.A.) 15 April 2014 (2014-04-15)<br>See paragraphs [0035]-[0038] and [0042] and claims 16 and 19. | 1-9 |
| Y | | 10-11 |
| Y | KR 10-1744078 B1 (YMT CO., LTD.) 07 June 2017 (2017-06-07)<br>See paragraph [0042]. | 10-11 |
| A | KR 10-2077555 B1 (GSCOMTECH CO., LTD.) 07 April 2020 (2020-04-07)<br>See claim 6. | 1-11 |
| A | KR 10-2012-0114648 A (UNITECH CO., LTD.) 17 October 2012 (2012-10-17)<br>See claims 4 and 6. | 1-11 |
| A | KR 10-0971555 B1 (UNITECH CO., LTD.) 21 July 2010 (2010-07-21)<br>See claim 1. | 1-11 |

☐ Further documents are listed in the continuation of Box C.  ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
|---|---|
| **07 July 2021** | **07 July 2021** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2019)

**INTERNATIONAL SEARCH REPORT**
Information on patent family members

International application No.

**PCT/KR2021/003483**

| Patent document cited in search report | | | Publication date (day/month/year) | Patent family member(s) | | | Publication date (day/month/year) |
|---|---|---|---|---|---|---|---|
| KR | 10-2014-0044768 | A | 15 April 2014 | BR | 112013015815 | A2 | 15 May 2018 |
| | | | | CA | 2822476 | A1 | 28 June 2012 |
| | | | | CA | 2822476 | C | 13 December 2016 |
| | | | | CN | 103339296 | A | 02 October 2013 |
| | | | | CN | 103339296 | B | 08 February 2017 |
| | | | | DE | 102010055968 | A1 | 28 June 2012 |
| | | | | DK | 2655702 | T3 | 17 May 2016 |
| | | | | EP | 2655702 | A1 | 30 October 2013 |
| | | | | EP | 2655702 | B1 | 06 April 2016 |
| | | | | ES | 2569991 | T3 | 13 May 2016 |
| | | | | JP | 2014-500404 | A | 09 January 2014 |
| | | | | MX | 2013007284 | A | 06 December 2013 |
| | | | | MX | 362153 | B | 24 December 2018 |
| | | | | PL | 2655702 | T3 | 31 August 2016 |
| | | | | US | 10011913 | B2 | 03 July 2018 |
| | | | | US | 2014-0127532 | A1 | 08 May 2014 |
| | | | | WO | 2012-084262 | A1 | 28 June 2012 |
| KR | 10-1744078 | B1 | 07 June 2017 | None | | | |
| KR | 10-2077555 | B1 | 07 April 2020 | None | | | |
| KR | 10-2012-0114648 | A | 17 October 2012 | KR | 10-1264089 | B1 | 14 May 2013 |
| KR | 10-0971555 | B1 | 21 July 2010 | None | | | |

Form PCT/ISA/210 (patent family annex) (July 2019)